(19) Europäisches Patentamt
European Patent Office
Office européen des brevets

(11) Publication number: **0 456 232 A1**

# (12) EUROPEAN PATENT APPLICATION

(21) Application number: **91107533.1**

(51) Int. Cl.5: **C25D 13/20**, H05K 9/00

(22) Date of filing: **08.05.91**

(30) Priority: **09.05.90 JP 119268/90**

(43) Date of publication of application:
**13.11.91 Bulletin 91/46**

(84) Designated Contracting States:
**DE FR GB**

(71) Applicant: **C. UYEMURA & CO, LTD**
**2-6 Dosho-machi 3-chome Chuo-ku**
**Osaka-shi Osaka(JP)**

(72) Inventor: **Matsui, Fujio, c/o Tokyo Branch**
**C. Uyemura & Co., Ltd., No. 1-2, Torigoe 1-chome**
**Taito-ku, Tokyo(JP)**
Inventor: **Suzuki, Yoichiro, c/o Chuo Kenkyujyo**
**C. Uyemura & Co., Ltd., No. 5-1, Deguchi 1-chome**
**Hirakata-shi, Osaka(JP)**
Inventor: **Tada, Masanori, c/o Chuo Kenkyujyo**
**C. Uyemura & Co., Ltd., No. 5-1, Deguchi 1-chome**
**Hirakata-shi, Osaka(JP)**
Inventor: **Kawakubo, Takeshi, c/o Tokyo Branch**
**C. Uyemura & Co., Ltd., No. 1-2, Torigoe 1-chome**
**Taito-ku, Tokyo(JP)**

(74) Representative: **TER MEER - MÜLLER - STEINMEISTER & PARTNER**
**Mauerkircherstrasse 45**
**W-8000 München 80(DE)**

## (54) Method for preparing electromagnetic shield layer.

(57) An electromagnetic shield layer is provided on a non-conductive substrate by electroless plating a copper coating on the substrate and electrodepositing an organic resin film thereon.

EP 0 456 232 A1

This invention relates to a method for preparing electromagnetic shield layers on plastic and non-conductive substrates.

It is well known in the art to form electromagnetic shield layers on plastic and other non-conductive substrates by depositing copper or nickel layers thereon. The formation of copper and nickel layers on plastic and other non-conductive substrates is carried out in a conventional manner, for example, by first degreasing, etching and otherwise appropriately pretreating the substrates, activating the substrates to form metallic palladium or silver nuclei on their surface, and then effecting electroless copper or nickel plating.

It is also known from US Patent No. 4,663,240 or Japanese Patent Application Kokai (JP-A) No. 500344/1987 to provide an electromagnetic shield layer by forming a nickel plating layer on a copper plating layer. Without an overcoat, the copper plating layer would gradually lose its shielding capacity due to oxidation in a service atmosphere. In the double plating structure, the nickel plating layer serves to prevent deterioration of the copper layer. The copper-nickel plating layer is usually formed by forming an organic binder layer having metal particles dispersed therein on a non-conductive substrate, electroless plating a copper layer on the substrate, and then electroless plating a nickel layer thereon.

In this way, electromagnetic shield layers of the copper-nickel double plating structure are formed by creating active metallic nuclei and then effecting electroless copper and nickel plating steps. These steps are low in productivity due to their electroless or chemical plating nature. This method is not well adapted for efficient production of electromagnetic shielding layers.

One approach toward efficient production is to substitute nickel electroplating for the second electroless nickel plating step because the first electroless copper plating step can not be omitted as is always necessitated by metal plating to non-conductors. In general, articles which are required to have electromagnetic shield layers born thereon are of relatively large size. Nickel electroplating on such large sized articles often yields plating layers of varying thickness, failing to form even plating layers.

An object of the present invention is to overcome the problems in the prior art. Another object of the present invention is to provide a method capable of forming an even electromagnetic shield layer on large sized parts to give satisfactory shield capacity while eliminating the problems of outer appearance and corrosion. A further object is to provide a method capable of forming an electromagnetic shield layer in a commercially acceptable manner with respect to efficiency and productivity.

These and other objects are attained by electroless plating a copper coating on a non-conductive substrate and electrodepositing an organic film thereon.

Making investigations on the prior art method for forming an electromagnetic shield layer involving electroless copper plating followed by electroless nickel plating, the inventors have found that by electrodepositing a resin film directly on the electroless copper coating while eliminating the electroless nickel plating, there is obtained a layered structure having equivalent electromagnetic shielding capacity to the Cu-Ni double layered structure, that is, the electroless nickel plating layer can be omitted. Electrodepositing process deposits within a short time an even, relatively thick film which firmly and closely adheres to the underlying copper layer to impart corrosion resistance at the interface and aesthetic appearance at the outer surface, eliminating the possibility of exposure of the underlying copper layer which often occurred due to abrasion of an electroless nickel coating particularly when it was thin. Furthermore, electrodepositing is a wet process which can be readily combined with a conventional plating line. A continuous wet process of electroless copper plating followed by electrodeposition is advantageous in a commercial aspect too. In addition, although the prior art process of electroless copper plating followed by electroless nickel plating requires intermediate activation such as creation of metallic palladium nuclei on the copper coating for electroless nickel deposition thereon, the electrodeposition does not require such activation, that is, electroless copper plating can be directly followed by electrodeposition.

Therefore, the present invention provides a method for preparing an electromagnetic shield layer on a non-conductive substrate, comprising the steps of: electroless plating a copper coating on the substrate, and electrodepositing an organic film thereon. Electromagnetic shield layers having improved appearance and corrosion resistance can be produced on large sized parts to a uniform thickness in a commercially acceptable manner.

The only figure, FIG. 1 is a diagram showing an electromagnetic wave damping capacity at varying frequency of the electromagnetic shield layers of Example and Comparative Examples.

The non-conductive substrates on which electromagnetic shield layers are formed according to the present invention are of plastic and ceramic materials and often of relatively large size. Electromagnetic shield layers are formed on non-conductive substrates by first degreasing, etching and otherwise appropriately pretreating the substrates and then activating the substrates to create metallic palladium or silver nuclei on their surface. Conventional well-known methods may be used for activation. For example, sensitizing-activating, catalyzing-activating and similar methods may be used when it is desired to create

metallic palladium nuclei. A method based on silver mirror reaction may be useful for depositing metallic silver nuclei.

The thus activated non-conductive substrates are then subjected to electroless copper plating in an electroless copper plating bath. The electroless copper plating bath used herein may be selected from conventional baths including commercially available ones containing formalin reducing agent and ones containing hypophosphite reducing agent. In general, baths containing a water-soluble copper salt, a complexing agent, and a reducing agent are useful. The copper salt is copper sulfate, cupric chloride or the like and contained in a concentration of 0.001 to 0.2 mol/liter. The complexing agent may be selected from well-known complexing agents for electroless copper plating purposes, for example, ethylenediamine, ethylenediamine tetraacetic acid (EDTA), tartaric acid, triethanolamine, trinitroacetic acid, and salts thereof. These complexing agents may be used alone or in admixture of two or more in an at least equimolar concentration to the copper salt concentration, preferably in a molar amount of 1 to 10 times, more preferably 2 to 10 times the moles of the copper salt. The reducing agent is preferably formalin and used in a concentration of up to 1 mol/liter, more preferably 0.05 to 1 mol/liter, especially 0.1 to 0.5 mol/liter. The bath may further contain a pH adjusting agent, buffer agent, stabilizer and other additives if necessary. The bath is desirably adjusted to pH 8 to 13, especially pH 10 to 13.

In the practice of the present invention, a non-conductive substrate having metallic palladium or silver nuclei born thereon is dipped in an electroless copper plating bath at a temperature of 20 to 95 °C as mentioned above. Electroless copper plating is continued preferably until the resulting copper coating reaches a thickness of about 0.5 to about 10 μm.

Electroless copper plating is followed by electrodeposition also known as electrocoating or electropainting.

For conditioning intermediate the electroless copper plating and the electrodeposition, pickling may be conducted if desired, although water rinsing is generally sufficient. Immediately after rinsing, electrodeposition can be initiated. By conducting electrodeposition directly on the copper coating, there is formed an organic film which firmly adheres to the underlying copper coating.

The electrodeposition may be either anodic or cathodic electrodeposition and use an electrodepositing composition which forms an organic film capable of curing at room temperature to 150 °C, preferably at room temperature to 120 °C. The electrodepositing composition may be of well-known formulation. That is, the electrodepositing composition is formulated to contain an effective amount of a commonly used coating resin such as acrylic resins, polyester resins, epoxy resins, and polybutadiene in water at a concentration of 5 to 60% by weight so that the resulting resin film may cure through any desired mechanism including curing reaction of epoxy groups, curing reaction of blocked isocyanate groups, curing reaction of melamine or phenolic resin, curing reaction of Michael reaction, and curing reaction of active double bonds (e.g., curing reaction by ultraviolet radiation, electron beams or the like).

For controlling corrosion resistance and physical properties such as smoothness, the electrodepositing composition may further contain a coloring pigment such as titanium dioxide and carbon black, an extender pigment such as talc and aluminum silicate, and a rust-preventing pigment such as strontium chromate and basic lead silicate.

To conduct electrodeposition, a constant voltage or current method may be employed. Constant voltage electrodeposition uses a voltage of about 10 to 500 volts, preferably 10 to 300 volts while constant current electrodeposition uses a current flow of about 1 to 1000 $mA/dm^2$, preferably 3 to 500 $mA/dm^2$ at room temperature.

If the non-conductive substrate to be covered with an electromagnetic shield is made of ABS resin or other plastic materials having a low softening point, an electrodepositing composition requiring drying and baking at high temperatures for a long time at the end of deposition should be avoided. In this respect, a preference is made to an electrodepositing bath which deposits an organic film capable of curing at low temperatures, especially up to 80 °C. Other useful electrodepositing compositions are of the photo-curable type and electron beam curable type.

Suitable low-temperature curable electrodepositing compositions are known from many patent publications.

JP-A 241976/1987 (October 22, 1987, Kansai Paint K.K.) discloses a room-temperature drying electrodeposition composition comprising (A) a water-soluble or dispersible product resulting from reaction between an epoxy resin and a drying oil fatty acid-modified vinyl copolymer having an acid value of 10 to 200 in a solids weight ratio of from 90/10 to 5/95, (B) water, and (C) an amphiphatic organic solvent. The organic solvent is blended in an amount of 15 to 500 parts by weight, preferably 30 to 200 parts by weight per 100 parts by weight (calculated as solids) of component (A). Coloring pigments, extender pigments, rust-preventing pigments, and surfactants may also be blended.

JP-A 295972/1987 (December 23, 1987, Kansai Paint K.K.) Discloses a cationic electrodeposition rein composition comprising a base resin and a curing agent in the form of a blocked polyisocyanate compound. The blocked polyisocyanate compound has one blocked isocyanate group having a blocking agent-dissociating temperature of about 80-120°C and at least one blocked isocyanate group which dissociates at a temperature higher by at least about 40°C than the first mentioned temperature in a molecule. The base resins include (i) reaction products of a polyepoxy resin and a cationic agent such as aliphatic, alicyclic or aromatic-aliphatic primary or secondary amines, tertiary amine salts, secondary sulfide salts, and tertiary phosphine salts, (ii) polycondensates of polycarboxylic acid and polyamine, protonated with an acid, (iii) polyaddition compounds of polyisocyanate, polyol, and mono- or polyamine, protonated with an acid, (iv) copolymers of acrylic or vinyl monomers containing hydroxyl and amino groups, protonated with an acid, and (v) addition compounds of polycarboxylic resin and alkyleneimine, protonated with an acid. Preparation of these cationic or base resins is described in Japanese Patent Publication Nos. 12395/1970, 12396/1970, and 23087/1974, USP 2,450,940, 3,403,088, 3,891,529, and 3,963,663.

JP-A 305178/1988 (December 13, 1988, Shimizu K.K.) discloses a low-temperature curable electrodeposition composition comprising in admixture, a vinyl copolymer consisting of (a) a compound of the formula:

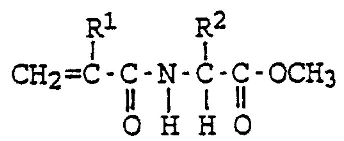

wherein $R^1$ is hydrogen or methyl, and $R^2$ is hydroxy, methoxy or methoxymethyl,
(b) acrylic acid or an analogue, (c) a hydroxyalkyl ester of acrylic or methacrylic acid, and (d) an alkyl ester of acrylic or methacrylic acid, styrene or an analogue and a polyamide or melamine resin. The preferred vinyl copolymer consists of 15 to 35% by weight of component (a), 3 to 15% by weight of component (b), 10 to 30% by weight of component (c), and the balance of component (d) and having a weight average molecular weight of 5,000 to 60,000.

JP-A 70574/1989 (March 16, 1989, The Dow Chemical Company) discloses a corrosion resistant, low-temperature curable, cathodic electrodeposition composition comprising (1) a cationic epoxy base resin, (2) a blocked isocyanate crosslinking agent which is unblocked at a temperature of lower than about 160°C, and (3) a solvent system containing an organic solvent, but substantially free of an organic solvent which reacts with an isocyanate group at the temperature used to cure the composition.

A typical photo-curable type electrodepositing composition is described in JP-A 262856/1987 as comprising a water-soluble or dispersible polymerizable unsaturated resin, a water-insoluble photopolymerization initiator, and a chelating agent. The polymerizable unsaturated resin has an acid value of 20 to 300, preferably 40 to 110, an unsaturation equivalent of 150 to 3,000, and a number average molecular weight of at least 300, preferably 1,000 to 30,000. The initiator such as benzoin and α-hydroxyisobutylphenone is used in an amount of 0.1 to 10 parts by weight per 100 parts by weight (calculated as solids) of the resin component. The chelating agents include β-diketones, acetoacetates, malonates, ketones having a hydroxyl group at β-position, aldehydes having a hydroxyl group at β-position, and esters having a hydroxyl group at β-position, and are used in an amount of up to 300 parts by weight, preferably 1 to 50 parts by weight per 100 parts by weight of the resin component.

The electrodeposited film may be formed to any desired thickness, preferably a thickness of about 5 to about 50 μm, more preferably about 10 to about 25 μm.

## EXAMPLE

Examples of the present invention are given below by way of illustration and not by way of limitation.

An ABS resin plate of 150 x 75 x 3 mm was degreased and etched in a conventional manner and then activated with the following activating solution, creating metallic palladium nuclei on the surface.

| | Step | Conditions |
|---|---|---|
| 1 | Degreasing* | 65°C/5 min. |
| | 2.5 vol% Cleaner Conditioner CD-102 | |
| 2 | Rinsing | 50°C/2 min. |
| 3 | Etching | 65°C/5 min. |
| | Anhydrous chromic acid 400 g/l | |
| | Sulfuric acid 400 g/l | |
| 4 | Pickling | 25°C/2 min. |
| | 10 vol% $H_2SO_4$ | |
| 5 | Predipping* | 25°C/2 min. |
| | PED-104 270 g/l | |
| 6 | Activating* | 30°C/10 min. |
| | PED-104 270 g/l, AT-105 3 vol% | |
| 7 | Accelerating* | 25°C/5 min. |
| | AT-106 10 vol% | |

* The chemicals used in these steps are plastic pretreatment chemicals commercially available from C. Uyemura & Co., Ltd.

The plate was then rinsed and subjected to electroless copper plating for 25 minutes under the following conditions, forming a copper coating of 1.1 µm thick.

<u>Electroless Cu plating bath</u>

| | |
|---|---|
| Copper sulfate | 0.03 mol/l |
| EDTA·4H | 0.25 mol/l |
| Formalin | 0.2 mol/l |
| 2,2'-bipyridyl | 10 mg/l |
| Polyethylene glycol 1000 | 100 mg/l |
| pH | 12.5 |

<u>Plating conditions</u>

| | |
|---|---|
| Time | 25 min. |
| Temperature | 60°C |

Next, the plate was dipped in an anodic electrodepositing bath containing an epoxy resin, a safflower oil-modified vinyl copolymer, water and butyl cellosolve as shown below. Electrodeposition was effected at a current density of 50 mA/dm$^2$ for 3 minutes, followed by drying at 40°C for 60 minutes. There was formed an organic film of 15 µm thick on the copper coating.

The anodic electrodepositing bath was prepared according to Example 1 of JP-A 241976/1987. More

particularly, a solution was prepared by dissolving 70% Epikote® 1007 (bisphenol-A epichlorohydrin type epoxy resin commercially available from Shell) in butyl cellosolve. A copolymer was prepared by effecting addition reaction between safflower oil fatty acid and glycidyl methacrylate, adding the fatty acid-modified monomer to n-butyl cellosolve along with styrene, n-butyl methacrylate, 2-ethylhexyl methacrylate, acrylic acid, and asobisdimethylvaleronitrile, and adding asobisisobutyronitrile to the reaction solution, obtaining the copolymer having a resin acid value of 55.8 and a Gardner viscosity of Z4. A reactor was charged with 288 parts by weight of the Epikote 1007 solution, 262 parts of the copolymer and 20 parts of triethylamine and reaction conducted at 90°C for one hour. The reaction product was diluted with water to form an aqueous solution (A) having a heating residue of 25.9%. Titanium dioxide pigment was added to solution (A) in an amount of 30 parts per 100 parts of the solids of solution (A). The mixture was dispersed in a paint conditioner. Then n-butyl cellosolve was added to the dispersion in an amount of 40 parts per 100 parts of the solids of solution (A). After 180 parts of n-octyl alcohol was added, the dispersion was diluted with deionized water such that the total content of the resins and pigment was 10%.

The thus deposited layer was examined for electromagnetic shielding capacity by placing the coated plate between a radiation source and a sensor to measure how electromagnetic radiation was shielded by the plate. The results are shown in FIG. 1 by plotting a damping capacity (dB) at a varying frequency (MHz).

For comparison purposes, a first comparative sample was prepared from the same substrate having an electroless copper coating thereon as above by electroless plating a nickel coating of 0.3 µm on the copper coating in an electroless nickel plating bath having the formulation shown below. A second comparative sample was prepared by electroless plating a nickel coating of 0.3 µm on a substrate. These comparative samples were also examined for electromagnetic shielding capacity. The results are also shown in FIG. 1.

<u>Electroless Ni plating bath</u>

| | | |
|---|---|---|
| Nickel sulfate | | 0.01 mol/l |
| Acetic acid + lactic acid | | 0.2 mol/l |
| Sodium hypophosphite | | 0.2 mol/l |
| Stabilizer | | 1 ppm |
| | pH | 4.5 |

<u>Plating conditions</u>

| | |
|---|---|
| Time | 5 min. |
| Temperature | 60°C |

As seen from FIG. 1, the electromagnetic shield layer of the copper coat-resin film arrangement according to the present invention provides equivalent electromagnetic shielding effect to that of the conventional copper-nickel coating arrangement, indicating that the nickel plating layer can be replaced by an electrodeposited organic film without sacrificing electromagnetic shield capacity.

There has been described a Cu plating-electrodepositing layer structure having equivalent electromagnetic shielding capacity to the conventional Cu-Ni double layered structure. Electrodeposition process can briefly deposit an even, relatively thick organic film which firmly and closely adheres to the underlying copper layer to impart corrosion resistance and aesthetic appearance, eliminating the possibilities of exposure of the underlying copper layer due to abrasion and of uneven coating. Thus an electromagnetic shield layer is produced on a non-conductive part in a commercially acceptable manner.

While the invention has been described with reference to a preferred embodiment, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

**Claims**

1. A method for preparing an electromagnetic shield layer on a non-conductive substrate, comprising the steps of:
   electroless plating a copper coating on the substrate,
   and
   electrodepositing an organic film thereon.

2. The method of claim 1 further including the step of activating the substrate on its surface prior to the electroless plating step.

3. The method of claim 1 wherein the electroless plating step uses an electroless copper plating bath containing a water-soluble copper salt, a complexing agent, and a reducing agent.

4. The method of claim 1 wherein the electroless plating step forms a copper coating to a thickness of 0.5 to 10 µm.

5. The method of claim 1 wherein the electrodepositing step uses an electrodepositing bath which contains a base resin selected from the group consisting of an acrylic resin, polyester resin, epoxy resin, and polybutadiene, and forms an organic resin film capable of curing at room temperature to 150 °C.

6. The method of claim 1 wherein the electrodepositing step forms an organic film to a thickness of 5 to 50 µm.

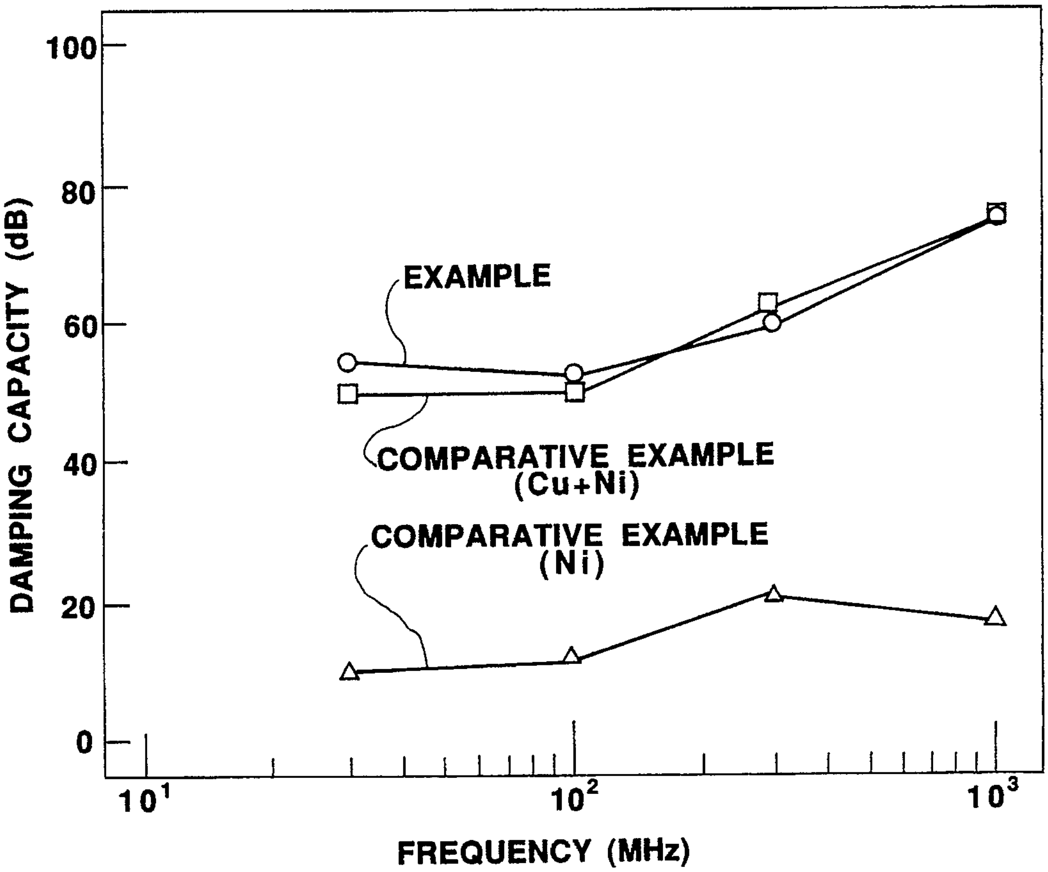
100
80
60
40
20
0
DAMPING CAPACITY (dB)
EXAMPLE
COMPARATIVE EXAMPLE (Cu+Ni)
COMPARATIVE EXAMPLE (Ni)
$10^1$
$10^2$
$10^3$
FREQUENCY (MHz)

European
Patent Office

# EUROPEAN SEARCH REPORT

Application Number

**EP 91 10 7533**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | WO-A-8 900 075 (CROWN CITY PLATING)<br>* Page 3, line 13 - page 5, line 6; page 8, lines 19,28 *<br>– – – | 1,2,3,5 | C 25 D 13/20<br>H 05 K 9/00 |
| A | PATENT ABSTRACTS OF JAPAN, vol. 11, no. 300 (C-449)[2747], 29th September 1987;<br>& JP-A-62 89 898 (C.REN K.K.) 24-04-1987<br>– – – – – | | |

| TECHNICAL FIELDS SEARCHED (Int. Cl.5) |
|---|
| C 25 D<br>H 05 K |

The present search report has been drawn up for all claims

| Place of search | Date of completion of search | Examiner |
|---|---|---|
| The Hague | 23 July 91 | NGUYEN THE NGHIEP |

CATEGORY OF CITED DOCUMENTS

X: particularly relevant if taken alone
Y: particularly relevant if combined with another document of the same catagory
A: technological background
O: non-written disclosure
P: intermediate document
T: theory or principle underlying the invention

E: earlier patent document, but published on, or after the filing date
D: document cited in the application
L: document cited for other reasons

&: member of the same patent family, corresponding document